# FASCICULE DE BREVET EUROPEEN

(11) **EP 4 156 436 B1**
(45) Date de publication et mention de la délivrance du brevet: **31.07.2024**
(21) Numéro de dépôt: 22197487.6
(22) Date de dépôt: 23.09.2022
(51) Int. Cl.: H02J 3/06

(54) **SYSTÈME DE DISTRIBUTION D'ÉLECTRICITÉ POUR UNE INSTALLATION DOMESTIQUE, PROCÉDÉ DE GESTION D'UN TEL SYSTÈME DE DISTRIBUTION D'ÉLECTRICITÉ**
STROMVERTEILUNGSSYSTEM FÜR EINE HAUSANLAGE, VERFAHREN ZUR VERWALTUNG EINES SOLCHEN STROMVERTEILUNGSSYSTEMS
ELECTRICITY DISTRIBUTION SYSTEM FOR A DOMESTIC INSTALLATION, METHOD FOR MANAGING SUCH AN ELECTRICITY DISTRIBUTION SYSTEM

(30) Priorité: 24.09.2021 FR 2110100
(43) Date de publication de la demande: 29.03.2023
(73) Titulaire: Schneider Electric Industries SAS, 92500 Rueil-Malmaison (FR)
(72) Inventeur: LEBEAU, Bernard, 38190 LES ADRETS (FR); DU PORT DE PONCHARRA, Etienne, 38570 CRETS EN BELLEDONNE (FR); BUR, Emmanuel, 38500 LA BUISSE (FR); FASSI, Brice, 38000 GRENOBLE (FR)
(74) Mandataire: Lavoix

(56) Documents cités:
- WO-A1-2016/176727
- WO-A1-2018/234330
- FR-A1- 2 432 789
- US-A1- 2021 083 506

## Description

L'invention concerne un système de distribution d'électricité pour une installation domestique. L'invention concerne également un procédé de gestion d'un tel système de distribution d'électricité.

De nos jours, il est courant que des installations domestiques de distribution d'électricité soient alimentées par plusieurs sources électriques, par exemple par un réseau public de distribution (« grid » en anglais) et par une source d'alimentation locale, tel qu'un ou plusieurs générateurs photovoltaïques (PV).

Souvent, les sources d'alimentation locales sont branchées sur des installations de distribution existantes. C'est par exemple le cas lorsque des générateurs photovoltaïques sont posés sur une habitation déjà pourvue d'une installation de distribution.

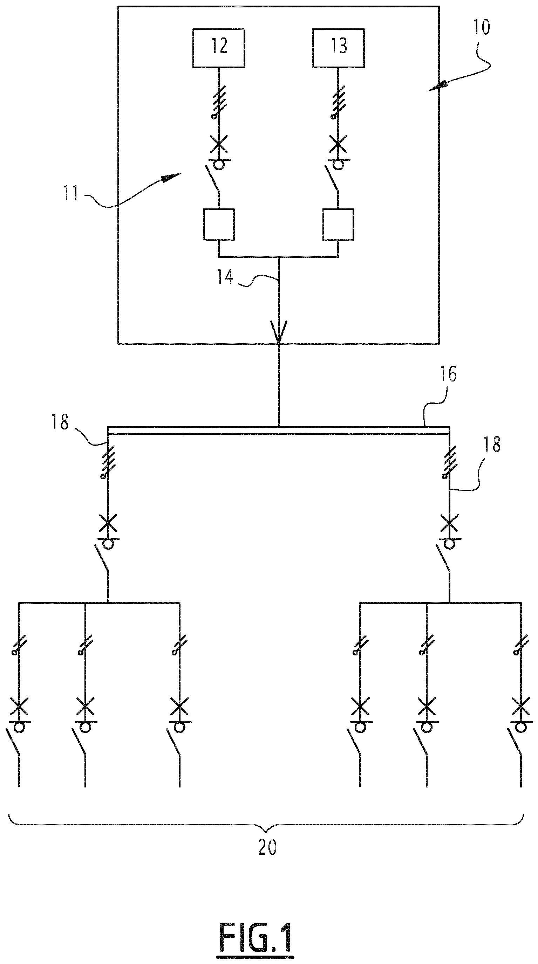

Pour des raisons de coût et de facilité d'installation, il est fréquent que ces sources d'alimentation locales soient branchées en amont de l'installation de distribution, aux côtés de l'arrivée du réseau public de distribution, et en aval du disjoncteur principal 11 (figure 1).

Dans ce cas, le disjoncteur principal 11 est incapable de protéger l'installation locale dans le cas où le courant électrique total (I_total) égal à la somme du courant issu du réseau (I_grid) et du courant issu de la source locale (I_PV) serait supérieur à un seuil de sécurité I_seuil (par exemple 63 ampères) lorsque les deux sources génèrent de l'électricité qui est consommée par les charges de l'installation domestique, puisque le disjoncteur principal 11 n'est pas situé sur la même branche de l'installation que la source d'alimentation locale.

De plus, dans de nombreux cas, les installations domestiques ne sont généralement pas prévues pour alimenter des charges de forte puissance pendant de longues durées, ce qui aggrave le risque de surintensité.

La figure 1 représente un exemple d'une telle configuration, dans laquelle une installation domestique de distribution d'électricité 10 est configurée pour être alimentée par un réseau public de distribution 12 et par des générateurs photovoltaïques 13, ces deux sources d'alimentation étant raccordés par un branchement commun 14 à une entrée d'un même répartiteur 16. La sortie du répartiteur 16 est connectée à des conducteurs 18 qui alimentent une pluralité de charges électriques domestiques 20.

Avec une telle configuration, le disjoncteur principal 11 peut ne pas se déclencher lorsque le courant total (I_total) est supérieur au seuil de sécurité I_seuil (courant maximum admissible par le tableau) alors que le courant issu du réseau (I_grid) reste inférieur au seuil de déclenchement du disjoncteur principal 11.

Une telle situation peut créer de graves problèmes de sécurité, tels qu'un risque d'incendie, et doit donc être évitée.

Le document US2021/083506 A1 est une demande de brevet concernant un système de gestion de charges électriques comportant une pluralité de circuits de dérivation, un système de capteur et un circuit de commande.

Le document WO 2018 234330 A1 est une demande internationale décrivant un procédé et un système d'alimentation électrique d'un réseau domestique embarqué dans une cabine de passagers.

Il existe un besoin pour une installation électrique domestique permettant de connecter facilement une ou plusieurs sources d'alimentation secondaires aux côtés de l'arrivée du réseau d'alimentation, sans compromettre la sécurité de l'installation.

A cet effet, un aspect de l'invention concerne un système de distribution électrique pour distribuer des courants électriques entre un réseau de distribution électrique et une installation domestique de distribution, dans lequel le système comporte :
▪ un répartiteur agencé pour distribuer un courant électrique dans l'installation, le répartiteur étant configuré pour être connecté, côté amont, à un réseau de distribution électrique et à au moins une source d'alimentation électrique secondaire, le répartiteur étant configuré pour être connecté, côté aval, à une pluralité des charges électriques,
▪ un dispositif électronique de commande connecté à des dispositifs de mesure associés aux sources et aux charges , ces dispositifs de mesure permettant de déterminer le courant électrique circulant dans l'installation et notamment le courant électrique véhiculé dans le réseau de distribution électrique,
▪ le dispositif électronique de commande étant configuré pour, en fonction du courant mesuré, gérer des paramètres d'alimentation d'au moins une partie des charges électriques afin de réduire le courant électrique consommé par ces charges électriques et/ou gérer des paramètres de fonctionnement d'au moins une partie des sources d'alimentation électrique secondaires pour réduire le courant électrique délivré par ces sources électriques, afin de respecter un premier seuil de courant imposé par un élément de protection entre l'installation électrique et le réseau de distribution électrique et un deuxième seuil de courant correspondant à une limite en courant imposée par le répartiteur afin d'éviter que le courant délivré par les sources électriques au travers du répartiteur dépasse la limite en courant imposée par le répartiteur.

Selon des aspects avantageux mais non obligatoires, un tel système peut incorporer une ou plusieurs des caractéristiques suivantes, prises isolément ou suivant toute combinaison techniquement admissible :
- gérer des paramètres d'alimentation d'au moins une partie des charges électriques comporte des étapes consistant au moins à déconnecter ou reconnecter automatiquement ladite ou lesdites charges électriques, ou moduler la consommation électrique de ladite ou desdites charges électriques ;
- ladite pluralité de charges électriques comporte un ou plusieurs des éléments suivants : un véhicule électrique ou une station de charge d'un véhicule électrique, un chauffe-eau, une pompe à chaleur, ou climatiseur, ou une pompe ;
- le système comporte un ou plusieurs dispositifs de commutation électrique pour sélectivement déconnecter ou reconnecter une ou plusieurs desdites charges électriques, le ou les dispositifs de commutation étant pilotés par le dispositif électronique de commande ;
- au moins une desdites charges électriques comporte un dispositif de régulation intégré connecté au dispositif électronique de commande, le dispositif de régulation intégré étant configuré pour piloter la consommation électrique de ladite charge électrique en fonction d'informations envoyées par le dispositif électronique de commande ;
- ladite charge électrique est une station de charge pour un véhicule électrique ;
- chacune desdites charges électriques est raccordée au répartiteur par l'intermédiaire d'un conducteur électrique ;
- au moins une source d'alimentation électrique secondaire comporte des générateurs photovoltaïques ;
- le système comporte au moins un système de stockage d'électricité pouvant être source ou charge ;
- une source d'alimentation électrique secondaire alternative comporte un groupe électrogène ;
- le répartiteur comporte des conducteurs électriques en cuivre ;
- l'élément de protection comporte un appareil de protection électrique tel qu'un disjoncteur ou un fusible ou un compteur d'énergie à limitation de puissance ;
- le répartiteur est également configuré pour être connecté, côté aval, à des charges électriques additionnelles, telles que des charges électriques domestiques, par exemple des éclairages.

Selon un autre aspect, l'invention concerne un procédé de gestion d'un système de distribution électrique pour distribuer des courants électriques entre un réseau de distribution électrique et un tableau électrique dans une installation domestique, dans lequel le système comporte un répartiteur et un dispositif électronique de commande, le répartiteur étant agencé pour distribuer un courant électrique dans l'installation, le répartiteur étant configuré pour être connecté, côté amont, à un réseau de distribution électrique et à au moins une source d'alimentation électrique secondaire, le répartiteur étant configuré pour être connecté, côté aval, à une pluralité de charges électriques, dans lequel le dispositif électronique de commande est configuré pour :
déterminer, au moyen de dispositifs de mesure associés aux sources et aux charges, les courants électriques circulant dans l'installation, et notamment le courant électrique véhiculé dans le réseau de distribution électrique,
en fonction du courant mesuré, gérer des paramètres d'alimentation d'au moins une partie des charges électriques , afin de réduire le courant électrique consommé par ces charges électriques et/ou gérer des paramètres de fonctionnement d'au moins une partie des sources d'alimentation électrique secondaires pour réduire le courant électrique délivré par ces sources électriques afin de respecter un premier seuil de courant imposé par un élément de protection entre l'installation électrique et le réseau de distribution électrique et un deuxième seuil de courant correspondant à une limite en courant imposée par le répartiteur afin d'éviter que le courant délivré par les sources électriques au travers du répartiteur dépasse la limite en courant imposée par le répartiteur.

L'invention sera mieux comprise et d'autres avantages de celle-ci apparaîtront plus clairement à la lumière de la description qui va suivre d'un mode de réalisation d'un système donné uniquement à titre d'exemple et faite en référence aux dessins annexés, dans lesquels :
[Fig 1] la figure 1 représente schématiquement une installation électrique selon l'état de la technique ;
[Fig 2] la figure 2 représente schématiquement une installation électrique conforme à l'invention ;
[Fig 3] la figure 3 représente schématiquement un procédé de fonctionnement de l'installation électrique de la figure 2 ;
[Fig 4] la figure 4 représente schématiquement une partie des étapes du procédé de fonctionnement de la figure 3 ;
[Fig 5] la figure 5 représente schématiquement une partie des étapes du procédé de fonctionnement de la figure 3 ;
[Fig 6] la figure 6 représente schématiquement une partie des étapes du procédé de fonctionnement de la figure 3

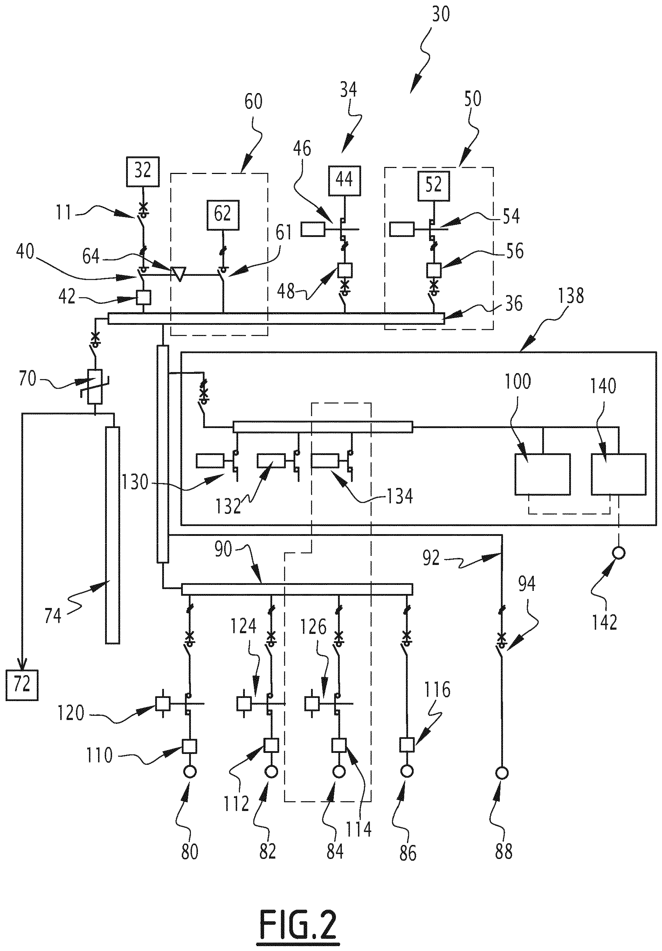

La figure 2 représente un mode de réalisation conforme à l'invention d'un système de distribution d'électricité 30 pour une installation domestique.

Dans de nombreux modes de réalisation, au moins une partie des constituants du système 30 sont logés dans un tableau électrique, ce dernier pouvant être au moins en partie installé dans un tableau électrique (par exemple un tableau mural) ou dans une armoire électrique.

Le système est configuré pour être alimenté par un réseau de distribution électrique 32 (secteur, ou « grid » en anglais) et par au moins une source d'alimentation secondaire 34.

Le système 30 comporte ici un point de raccordement comportant des bornes de raccordement destinées à être connectées au réseau 32. Selon les modes de réalisation, il peut s'agir d'un point de raccordement monophasé ou polyphasé (par exemple triphasé) avec ou sans ligne de neutre.

Entre le système 30 et le réseau 32 (appelé « Grid » en anglais) se trouve un élément de protection, qui porte ici la référence numérique 11. Cet élément de protection 11 peut comporter un appareil de protection électrique, tel qu'un disjoncteur ou un fusible ou un compteur d'énergie à limitation de puissance, par exemple.

Dans l'exemple illustré, l'élément de protection 11 comporte un disjoncteur, dit disjoncteur principal, qui correspond au disjoncteur principal 11 décrit en référence à la figure 1.

On comprend donc que la contrainte visant à surveiller voire limiter le courant circulant au travers de cet élément de protection 11 pour ne pas dépasser le seuil de déclenchement I_seuil, peut être généralisée au cas où l'élément de protection 11 est autre chose qu'un disjoncteur. Il s'agit alors, par exemple, de ne pas dépasser un courant qui pourrait conduire à l'endommagement d'un conducteur électrique de l'élément de protection 11, par exemple.

Le système 30 comporte également un répartiteur 36 agencé pour distribuer un courant électrique dans l'installation.

Le répartiteur 36 permet de connecter plusieurs charges électriques à une même arrivée de courant, pour chaque conducteur de phase électrique (ainsi que pour la ligne de neutre, si applicable, selon le type d'installation).

Dans cet exemple, l'installation électrique est une installation monophasée avec une ligne de neutre, d'autres exemples étant néanmoins possibles en variante. Par exemple, le système 30 pourrait être adapté pour fonctionner dans une installation triphasée.

Dans de nombreux modes de réalisation, le répartiteur 36 comporte une pluralité de barres de connexion, ou rails de connexion, de préférence en cuivre ou dans tout matériau électriquement conducteur approprié, chaque barre de connexion étant par exemple associée à une phase électrique (ou à une ligne de neutre).

Par exemple, le répartiteur 36 et dimensionné pour supporter et distribuer un courant électrique d'intensité supérieure ou égale à 96 ampères, par exemple supérieure ou égale à 120 ampères.

Le répartiteur 36 est configuré pour être connecté, côté amont, au réseau de distribution électrique 32 et à chacune des sources d'alimentation secondaires.

De préférence, un interrupteur sectionneur 40 situé en aval de l'élément de protection 11 est connecté entre le réseau 32 et le répartiteur 36. Par exemple, l'interrupteur sectionneur est un interrupteur modulaire (« miniature switch » en anglais). Par exemple, le calibre en courant de l'interrupteur sectionneur 40 est dimensionné pour véhiculer le courant de l'élément de protection 11, par exemple 63 ampères.

Le disjoncteur principal est donc connecté en amont du répartiteur 36.

Le seuil de courant avec lequel est réglé ce disjoncteur principal, dépend généralement de l'abonnement souscrit auprès du gestionnaire du réseau 32.

En aval de l'interrupteur sectionneur 40 est ici connecté un dispositif de mesure 42, par exemple configuré pour mesurer un courant électrique et/ou une puissance électrique transitant par le ou les conducteurs électriques correspondants. Le rôle de ce dispositif de mesure 42 sera explicité dans ce qui suit.

Dans l'exemple illustré, le système 30 comporte plusieurs sources d'alimentation électrique secondaire, dont des exemples seront décrits ci-après en référence à la configuration illustrée sur la figure 2. Le nombre et la nature des sources d'alimentation électrique secondaires peut être différent selon les modes de réalisation possibles.

De préférence, au moins une source d'alimentation électrique secondaire ou générateur comporte des panneaux photovoltaïques (PV). Le système 30 peut ainsi comporter un ou plusieurs générateurs photovoltaïques agissant en tant que source d'alimentation électrique secondaire. Il peut aussi comporter un système de stockage d'électricité sur batterie « dimmable » pouvant être source ou charge.

Dans l'exemple illustré, la première source d'alimentation électrique secondaire 34 comporte un premier générateur photovoltaïque 44 composé de panneaux photovoltaïques associés à un onduleur connecté au répartiteur 36, par exemple, par l'intermédiaire de conducteurs électriques ici pourvus d'un relais de protection 46 et d'un disjoncteur différentiel équipé d'un circuit de mesure 48. Le relais de protection 46 et/ou le disjoncteur différentiel équipé d'un circuit de mesure 48 pourraient toutefois être déportés en variante en dehors du système 30.

Toujours dans l'exemple illustré, la deuxième source d'alimentation électrique secondaire 50 comporte un deuxième générateur photovoltaïque 52 similaire à 44 connecté au répartiteur 36, par exemple, par l'intermédiaire de conducteurs électriques ici pourvus d'un relais de protection 54 et d'un disjoncteur différentiel équipé d'un circuit de mesure 56 similaires à ceux de la source 34.

Dans l'exemple illustré, la troisième source 60 est une source de secours de type groupe électrogène 62. Le système comporte un interrupteur sectionneur (non repéré) inter verrouillé avec l'interrupteur sectionneur 40 et raccordé au répartiteur 36.

Dans certains modes de réalisation, un système de stockage d'électricité, comportant par exemple un ensemble de batteries électrochimiques, pourrait être utilisé comme source d'alimentation électrique additionnelle.

Cette source de secours optionnelle 60 comporte un enclenchement de sécurité 64, ou dispositif de verrouillage (« interlocking » en anglais) qui permet d'inter verrouiller la source 32 avec la source 62 pour n'autoriser qu'une seule de ces deux sources à être connectée au répartiteur 36. Autrement dit, le dispositif 64 permet de choisir laquelle des sources 32 ou 62 alimente le répartiteur 36, en empêchant les deux sources d'être connectées simultanément.

Dans l'exemple illustré, le dispositif 64 comporte un premier interrupteur, par exemple l'interrupteur sectionneur 40 précédemment mentionné, qui est placé entre le point de raccordement du réseau 32 et le répartiteur 36, et un deuxième interrupteur 61 placé entre le groupe électrogène 62 et le répartiteur 36. Par exemple, le deuxième interrupteur est maintenu dans l'état ouvert tant que le premier interrupteur est dans l'état fermé, et vice versa.

Le dispositif 64 peut être de type mécanique ou électromécanique ou électronique, d'autres modes de réalisation étant néanmoins possibles.

En variante, la ou les sources 50 et/ou 60 pourraient être omises.

Optionnellement, le système 30 peut comporter un dispositif de protection contre la foudre. Ce dispositif de protection contre la foudre est connecté au répartiteur 36, par exemple du côté aval du répartiteur 36. Dans l'exemple illustré, le dispositif de protection contre la foudre comporte une varistance 70 connectée entre le répartiteur 36 et un point de raccordement à la terre 72 de l'installation électrique connecté au bornier de raccordement à la terre 74.

Le répartiteur 36 est également configuré pour être connecté, côté aval, à une pluralité de charges électriques.

Le répartiteur 36 est ainsi apte à alimenter électriquement les charges électriques, en transférant au moins une partie du courant électrique généré par une ou par plusieurs des sources électriques 32, 34, 50 et 60 connectées en amont. Ces charges principales sont ici connectées en parallèle.

Sur la figure 2, les charges électriques correspondent aux références 80, 82, 84, 86 et 88 étant entendu que cet exemple n'est pas limitatif et qu'un nombre différent de charges électriques peut être prévu en variante.

Dans de nombreux modes de réalisation, parmi ces charges électriques, deux types de charges électriques peuvent être distinguées : des charges électriques dites critiques (ou charges principales) 80, 82, 84 et 86 et des charges électriques domestiques 88 (ou charges secondaires).

Par exemple, les charges électriques principales 80, 82, 84 et 86 correspondent à des charges électriques susceptibles de consommer des puissances électriques importantes (par rapport à des charges électriques domestiques ordinaires) et/ou de consommer des courants électriques d'intensité électrique élevée, et/ou d'être actives en continu pendant de longues durées (par exemple pendant plus de 10 heures).

Par exemple, les charges électriques principales comportent un ou plusieurs des éléments suivants : un véhicule électrique ou une station de charge d'un véhicule électrique, un chauffe-eau, une pompe à chaleur (ou climatiseur, ou plus généralement une installation de chauffage domestique), un climatiseur ou un système de chauffage de piscine.

Dans l'exemple illustré, ces charges correspondent aux références 80, 82, 84 et 86.

Par comparaison, les charges électriques domestiques, représentées sur la figure 2 par la référence numérique 88, consomment une puissance électrique moindre et leur fonctionnement est généralement intermittent.

Par exemple, les charges électriques domestiques 88 sont des éléments d'éclairage, ou des appareils domestiques branchés sur des prises électriques domestiques, tels que des appareils électroménagers, des appareils multimédia, des équipements informatiques, des luminaires, ces exemples n'étant pas limitatifs.

En pratique, chacune desdites charges électriques 80, 82, 84, 86 et 88 est raccordée au répartiteur 36 par l'intermédiaire d'un conducteur électrique (ou de plusieurs conducteurs de phase et/ou de neutre, selon la nature de l'installation électrique).

De préférence, les conducteurs électriques sont dimensionnés en fonction du courant maximal admissible par charge électrique correspondante, par exemple en étant dimensionnés au plus juste pour ne pas avoir à surdimensionner les conducteurs électriques. Cela permet d'économiser la quantité de matière utilisée et donc de réduire le coût de l'installation.

Par exemple, les charges électriques principales 80, 82, 84 et 86 peuvent être raccordées au répartiteur 36 par l'intermédiaire de conducteurs associés à des peignes de distribution 90 (ou un répartiteur secondaire), comme c'est le cas des illustrées sur la figure 2, ou elles peuvent être raccordées directement au répartiteur 36 par un conducteur électrique.

Les charges électriques secondaires 88, dont les bornes de connexion sont généralement rassemblées dans un coffret secondaire, peuvent quant à elles être raccordées directement au répartiteur 36 par un conducteur électrique 92 protégé par un disjoncteur 94 dont le calibre est dimensionné pour ne pas dépasser le courant maximal admissible du coffret secondaire, par exemple 63 A.

En pratique, les conducteurs électriques sont raccordés à des bornes de jonction permettant de connecter ces charges électriques. Les charges électriques secondaires 88 peuvent être raccordées par de multiples câbles ou conducteurs secondaires distribués depuis le coffret secondaire.

Dans l'exemple illustré, la charge 80 est un chauffe-eau électrique comportant au moins un premier moyen de chauffage tel qu'une pompe à chaleur ou une résistance électrique. La charge 82 est une pompe à chaleur (ou climatiseur). La charge 84 est autre charge pilotée (par exemple une pompe de piscine). La charge 86 est une station de recharge d'un véhicule électrique. Cet exemple n'est pas limitatif, d'autres modes de réalisation étant possibles en variante. Par exemple, le chauffe-eau électrique pourrait ne comporter qu'un seul moyen de chauffage (la résistance par exemple).

Le système 30 comporte également un dispositif électronique de commande 100 configuré pour gérer automatiquement la répartition du courant électrique entre les charges électriques.

Dans de nombreux modes de réalisation, le dispositif électronique de commande 100 est implémenté par un ou plusieurs circuits électroniques, par exemple par un contrôleur logique programmable (PLC).

Par exemple, le dispositif électronique de commande 100 comporte un processeur, tel qu'un microcontrôleur programmable ou un microprocesseur. Le processeur est couplé à une mémoire informatique, ou à tout support d'enregistrement de données lisible par ordinateur, qui comporte des instructions exécutables et/ou un code logiciel prévu pour mettre en oeuvre un procédé de gestion du système 30 qui sera décrit ci-après lorsque ces instructions sont exécutées par le processeur.

L'emploi du terme « processeur » ne fait pas obstacle à ce que, en variante, au moins une partie des fonctions du dispositif électronique de commande 100 soient réalisées par d'autres composants électroniques, tels qu'un processeur de traitement du signal (DSP), ou un composant logique reprogrammable (FPGA), ou un circuit intégré spécialisé (ASIC), ou tout élément équivalent, ou toute combinaison de ces éléments.

Notamment, le dispositif électronique de commande 100 est configuré pour gérer des paramètres d'alimentation d'au moins une partie des charges électriques et/ou déconnecter ou reconnecter automatiquement une ou plusieurs des charges électriques en fonction du courant mesuré, lorsque le courant circulant au travers du répartiteur 36 dépasse un seuil de courant, tel qu'un seuil de protection.

Par exemple, le dispositif électronique de commande 100 est connecté à des capteurs permettant de déterminer le courant électrique circulant dans l'installation.

De préférence, le système 30 comporte des dispositifs pour mesurer des grandeurs électriques, telles que le courant et/ou la tension électrique et/ou la puissance électrique, associés aux charges électriques (au moins pour les charges principales) et aux sources électriques. Ces dispositifs de mesure peuvent comporter des capteurs de courant et/ou des capteurs de tension ou tout autre appareil de mesure approprié. Par exemple, sur la figure 2, des circuits de mesure 110, 112, 114 et 116 mesurent les courants circulant vers les charges principales 80, 82, 84 et 86. Les dispositifs de mesure 42, 48 et 56 associées aux sources électriques peuvent aussi être utilisés à cette fin.

Cela permet de déterminer le courant électrique circulant dans l'installation et notamment le courant électrique circulant au travers du répartiteur 36. Idéalement, un dispositif de mesure 42 est associé à la source 32, à chaque source secondaire ainsi qu'à chaque charge électrique principale.

Le dispositif électronique de commande 100 est également connecté à des dispositifs de commutation électrique, tels que des interrupteurs pilotables à distance, pour sélectivement déconnecter ou reconnecter une ou plusieurs des charges électriques, voire toutes les charges électriques. Les dispositifs de commutation électrique peuvent être des relais, ou des contacteurs, ou des interrupteurs de puissance à base de semi-conducteurs, ou tout autre appareil équivalent.

Dans l'exemple de la figure 2, à chaque charge principale 80, 82 et 84 est associé un dispositif de commutation électrique (respectivement numérotés 120, 124 et 126) qui est sélectivement et réversiblement commutable entre un état ouvert et un état fermé pour respectivement déconnecter la charge correspondante du répartiteur ou pour connecter cette charge au répartiteur 36.

Le dispositif électronique de commande 100, ici placé dans un ensemble de commande 138, est configuré pour piloter les dispositifs de commutation électrique 120, 124 et 126 afin de gérer des paramètres d'alimentation d'au moins une partie des charges électriques.

Notamment, le dispositif 100 est configuré pour, en fonction du courant mesuré, gérer des paramètres d'alimentation d'au moins une partie des charges électriques, afin de réduire le courant électrique consommé par ces charges et/ou gérer des paramètres de fonctionnement d'au moins une partie ces charges électrique pour réduire le courant électrique consommé par ces charges électriques afin de respecter le seuil de courant imposé par un disjoncteur principal connecté entre l'installation électrique et le réseau de distribution électrique.

Le dispositif 100 est également configuré pour gérer les paramètres d'alimentation d'au moins une partie des charges électriques afin d'éviter que le courant délivré par les sources électriques au travers du répartiteur dépasse la limite en courant imposée par le répartiteur.

Par exemple, il peut s'agir de déconnecter ou reconnecter automatiquement une ou plusieurs des charges électriques en fonction du courant mesuré dans le cadre d'une action de délestage, pour éviter que le courant consommé circulant au travers du répartiteur 36 dépasse le seuil de protection, et/ou encore pour ajuster la puissance électrique consommée par les charges électriques en fonction de la puissance électrique souscrite auprès du gestionnaire du réseau 32 (sur laquelle est calé le seuil du disjoncteur principal 11) et de la puissance électrique que les sources secondaires 34, 50 et 60 sont en mesure de fournir.

Dans l'exemple illustré, le dispositif électronique de commande 100 est associé à des lignes de commande qui sont respectivement associées aux dispositifs de commutation électrique 120, 124 et 126. Ces lignes sont connectées à un répartiteur secondaire 90 alimenté depuis le répartiteur 36 et sont chacune pourvue d'un interrupteur pilotable, tel qu'un relais ou un interrupteur de puissance à semi-conducteurs, notés 130, 132 et 134, afin de déclencher la commutation du dispositif de commutation électrique correspondant en alimentant sélectivement la ligne de commande.

Lorsque l'interrupteur 120, 124 ou 126 est dans l'état ouvert, la charge électrique correspondante est déconnectée du système 30 et ne peut pas être alimentée électriquement par un courant circulant depuis le répartiteur 36.

Selon la nature de l'installation électrique, le dispositif électronique de commande 100 peut, également ou alternativement, être connecté à des moyens de pilotage, tel qu'un dispositif de régulation intégré à certaines des charges électriques, pour piloter à distance ces charges électriques (par exemple pour réduire leur consommation ou pour les arrêter temporairement).

Cela est notamment le cas de charges telles qu'une pompe à chaleur (ou climatiseur), ou un appareil de chargement pour véhicule électrique, tel que la charge 86 de l'exemple illustré sur la figure 2, qui comportent généralement de tels dispositifs de régulation (usuellement implémentés par des contrôleurs électroniques) qui peuvent communiquer avec le dispositif électronique de commande 100.

Par exemple, la communication entre le dispositif électronique de commande 100 et le dispositif de régulation de la borne de recharge pour véhicule électrique (borne 142 sur la figure 2) est ici réalisée grâce à une liaison suivant le protocole Open Charge Point Protocol (OCPP). D'autres modes de communication pourraient être utilisés en variante.

Dans l'exemple illustré, le dispositif électronique de commande 100 comporte une interface de communications 140 telle qu'un routeur ou une passerelle, qui est en communications avec un dispositif de commande d'une des charges principales (par exemple, la station de chargement 86), voire avec un réseau de communications extérieur (par exemple le réseau internet).

Dans d'autres cas, les charges principales peuvent être pilotées en alimentant électriquement (ou en interrompant l'alimentation) une borne de jonction secondaire raccordée à une entrée de commande de la charge électrique.

Grâce à l'invention, le système de distribution permet d'associer facilement plusieurs sources d'alimentation (et plus particulièrement une source photovoltaïque et un réseau public) pour alimenter une installation domestique comportant une pluralité de charges électriques de nature différente, tout en évitant que l'association de plusieurs sources électriques ne génère des courants électriques dont l'intensité serait dangereuse pour l'installation et instable en cas d'absence de production du panneau photovoltaïque.

Le dispositif 100 permet notamment de surveiller et de réguler deux aspects : d'une part, garantir le respect du contrat souscrit auprès du gestionnaire du réseau 32 (ou, plus généralement, respecter le seuil de courant défini par l'élément de protection 11) et, plus généralement, gérer l'autoconsommation du système, c'est-à-dire gérer la puissance électrique fournie par les sources secondaires.

D'autre part, il s'agit de protéger le répartiteur 36 et de veiller notamment à ce que la somme des courants provenant des différentes sources, notamment lorsque les sources secondaires sont au moins en partie actives, n'excède pas les limites permises par le répartiteur 36 et par l'installation en général.

En variante, le dispositif 100 pourrait n'être configuré que pour surveiller et réguler un seul de ces deux aspects : respecter le seuil de courant défini par l'élément de protection 11 et gérer l'autoconsommation du système, ou protéger le répartiteur 36.

On comprend donc que les modes de réalisation permettant de gérer chacun de ces aspects peut être mis en oeuvre indépendamment des modes de réalisation permettant de gérer l'autre de ces aspects. Et que dans de nombreux modes de réalisation, le dispositif 100 est capable de gérer ces deux aspects.

La régulation du courant est réalisée automatiquement sans avoir besoin de rajouter des disjoncteurs pour chaque source électrique secondaire. De plus, comme la répartition des courants électriques dans l'installation est maîtrisée (en délestant une ou plusieurs charges lorsque le courant circulant dans les branches correspondantes devient trop élevé), cela permet de dimensionner les conducteurs et le répartiteur 36 au plus près des besoins. On évite ainsi de surdimensionner excessivement les conducteurs électriques de l'installation, un tel surdimensionnement ayant généralement pour effet d'engendrer un coût de fabrication plus élevé et un poids plus important (dans le cas de conducteurs en cuivre, par exemple). Cette double surveillance procure en outre un avantage en terme de confort pour les utilisateurs, en évitant des déclenchements intempestifs du disjoncteur principal.

De façon générale, le dispositif électronique de commande 100 est configuré pour gérer la consommation des charges afin de réduire le courant délivré par les sources électriques (telles que le courant issu du réseau 32 et acheminé par le disjoncteur principal) au travers du répartiteur 36.

Le dispositif 100 est configuré pour surveiller ce courant et pour piloter les charges électriques principales et/ou les sources secondaires afin de respecter le seuil de sécurité (I_seuil) du disjoncteur principal afin d'éviter toute disjonction intempestive, qui aurait un impact négatif sur le confort des utilisateurs de l'installation électrique.

En même temps, le dispositif 100 est configuré pour surveiller ce courant et pour piloter les charges électriques principales et/ou les sources secondaires pour respecter la limite imposée par le répartiteur 36 (par exemple un courant électrique d'intensité 96 A ou 120 A). Le dispositif 100 peut aussi être configuré pour surveiller une injection de courant vers le réseau (liée à une consommation des charges moindres que la production totale des sources additionnelles) pour forcer une consommation par les charges électriques.

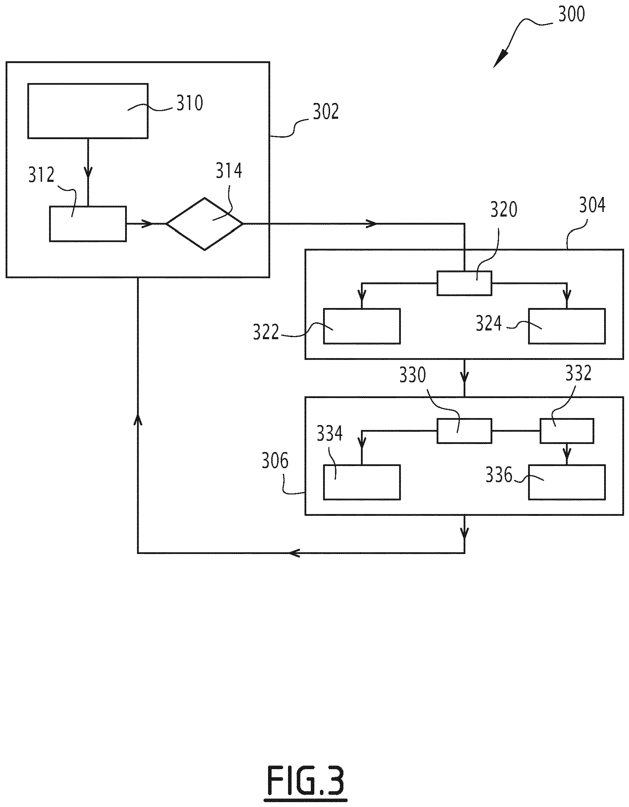

La figure 3 représente un exemple d'un procédé de gestion du système 30 ou 200 mis en oeuvre par le dispositif électronique de commande 80.

Notons qu'en variante, les étapes pourraient être exécutées dans un ordre différent. Certaines étapes pourraient être omises. L'exemple décrit ne fait pas obstacle à ce que, dans d'autres modes de réalisation, d'autres étapes soient mises en oeuvre conjointement et/ou séquentiellement avec les étapes décrites.

De façon générale, comme illustré par le schéma 300, le dispositif électronique de commande est configuré pour :
- déterminer, au moyen de capteurs permettant de déterminer le courant électrique circulant dans l'installation (bloc 302),
- gérer des paramètres d'alimentation d'au moins une partie des charges électriques et/ou déconnecter ou reconnecter automatiquement une ou plusieurs des charges électriques en fonction du courant mesuré,. Cela correspond à des étapes de délestage (bloc 304) et de rétablissement (bloc 306) des charges électriques concernées.

De façon générale, comme expliqué précédemment, le procédé présente une double finalité.

D'une part, il s'agit de surveiller et gérer la consommation des charges électriques en fonction du contrat souscrit auprès du gestionnaire du réseau 32, notamment pour que le courant fourni par le réseau ne dépasse pas le seuil fixé par l'abonnement (par exemple, 40 A ou 60 A) car cela pourrait conduire à un déclenchement du disjoncteur principal.

D'autre part, il s'agit d'éviter que le courant circulant au travers du répartiteur dépasse un seuil de courant, notamment pour éviter que les courants fournis par le réseau 32 et par les sources intermittentes ne devienne supérieur au seuil de protection défini en fonction du courant admissible par le répartiteur 36.

Ainsi, les étapes de ce procédé peuvent être mises en oeuvres plusieurs fois : une première fois pour détecter si le courant fourni par le réseau 32 dépasse le seuil fixé par l'abonnement (I_Grid par rapport à I_seuil de l'élément 11) et une deuxième fois pour détecter si le courant dépasse le seuil de protection (I_grid + I_somme_des_sources) supérieur à I_Seuil du répartiteur 36. Ces séquences d'étapes doivent être elles même répétées au cours du temps.

Dans ce qui suit, on va décrire les étapes en référence à la deuxième application (que le courant fourni par le réseau ne dépasse pas le seuil de courant admissible par le répartiteur 36) mais on comprend qu'en pratique ces étapes seront aussi utilisées pour la première application.

Dans l'exemple illustré, à l'étape 302, le dispositif 100 mesure des grandeurs électrique au moyen des capteurs et des dispositifs de mesure 42, 48, 56, 110, 112, 114 et 116 et détermine (directement et/ou par des calculs) des valeurs de courants électriques et/ou des valeurs de puissance électrique en un ou plusieurs emplacements de l'installation de distribution.

Ensuite, le dispositif 100 compare les grandeurs mesurées 310 avec des grandeurs de référence, pouvant être des seuils de protection dont le dépassement indique l'apparition d'une surintensité.

Dans certains exemples, la comparaison peut être réalisée en calculant un rapport entre des grandeurs électriques (une grandeur électrique mesurée et une limite prédéfinie) et comparer ce rapport à une valeur numérique prédéfinie.

Par exemple, on utilise un indicateur nommé « rapport de courant » qui est défini comme égal au rapport du courant circulant en un point de l'installation (dans le répartiteur 36) divisé par un seuil de courant, tel que le seuil de protection précédemment défini (par exemple égal à 96A ou à 120 A).

En variante, on pourrait utiliser un rapport de puissance défini comme égal à la puissance électrique délivrée par le réseau 32 divisée par une limite de puissance électrique prédéfinie (ces puissances pouvant être des puissances instantanées, ou des puissances moyennées sur une même durée)

Par exemple, au moins l'un desdits rapports est calculé lors de l'étape 312, puis à l'étape 314, le dispositif 100 détermine si une surintensité a été identifiée à partir de la valeur du ou des rapports calculés.

Si une surintensité a été identifiée, alors au bloc 304 le dispositif 100 met en oeuvre un procédé de délestage pour interrompre le fonctionnement d'au moins une des charges principales, afin de réduire la consommation électrique et ainsi réduire le courant délivré par les sources électriques au travers du répartiteur 36 ou de l'élément de protection 11 et/ou adapter la consommation en fonction de la puissance disponible sur le réseau 32 (en fonction du contrat de fourniture souscrit, qui limite la puissance ou le courant disponible) et la puissance disponible sur les sources secondaires, notamment sur les sources intermittentes telles que les générateurs photovoltaïques 44 et 52.

Par exemple, lors d'une étape 320, le dispositif 100 détermine automatiquement quelles charges peuvent être délestées. Par exemple, une liste des charges électriques gérées par le système et de leurs caractéristiques est au préalable enregistré en mémoire.

Cette détermination est par exemple mise en oeuvre suivant une loi de commande prédéfinie, par exemple au moyen d'algorithmes de gestion de délestage connus.

En pratique, selon la nature des charges électrique présentes, il est possible de réduire leur consommation graduellement sans interrompre totalement la charge électrique (« dimmable charges » en anglais) ou bien d'interrompre complètement la charge (et donc d'arrêter leur consommation) en les déconnectant ou en les arrêtant.

Un exemple de charge réglable dont la consommation peut être variée graduellement est un équipement de chauffage ou de climatisation dont la température de consigne peut être modifiée pour chauffer moins (ou moins refroidir). Il peut aussi s'agir d'une borne de chargement de véhicule électrique dont le débit de recharge est diminué.

Lorsqu'applicable, cette régulation est réalisée au moyen du dispositif de régulation intégré à la charge électrique correspondante.

Ainsi, suite à l'étape 320, le dispositif 100 envoie automatiquement des ordres pour réduire la consommation d'une ou de plusieurs charges (étape 322) et/ou des ordres pour déconnecter une charge (étape 324).

Selon la nature de la charge et sa connexion au système 30, l'ordre de déconnexion est envoyé directement à la charge pour qu'elle s'interrompe elle-même, ou à un dispositif de commutation situé entre le répartiteur 36 et une entrée d'alimentation de la charge, ainsi que cela sera expliqué plus en détail au travers d'exemples présentés ci-après.

Ensuite, lors de l'étape 306, la ou les charges sont rétablies, par exemple une fois que la condition de défaut a disparu et/ou à l'expiration d'un délai de temporisation prédéfini.

Par exemple, lors de l'étape 330, le dispositif 100 détermine automatiquement laquelle ou lesquelles des charges précédemment ciblées peuvent être rétablies. Cette détermination peut être réalisée en fonction de caractéristiques connues desdites charges, suivant une loi de commande prédéfinie, à l'image du procédé de l'étape 320.

Ainsi, suite à l'étape 330, le dispositif 100 envoie automatiquement des ordres pour rétablir graduellement la consommation d'une ou de plusieurs charges variables (étape 334) et/ou des ordres pour reconnecter une charge (étape 336) après un délai de temporisation (étape 332).

L'étape 302 est ensuite répétée.

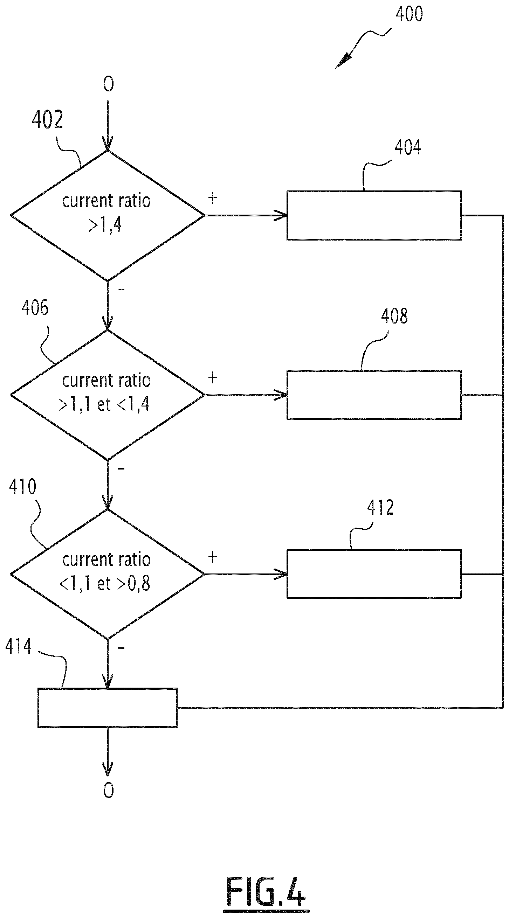

La figure 4 représente un exemple de mise en oeuvre simplifiée des étapes de délestage d'une ou de plusieurs charges électriques du système du procédé de la figure 3.

Le procédé 400, qui détaille un exemple de fonctionnement de l'étape mise en oeuvre au bloc 302 susmentionné, débute après que les rapports précédemment décrits ont été calculés.

A l'étape 402, le rapport de courant (noté « current_ratio » sur la figure 4) est comparé à un premier seuil (ici choisi égal à 1,4 bien que d'autres exemples soient possibles). Si le rapport calculé est supérieur au premier seuil, alors la ou les charges concernées sont immédiatement interrompues (étape 404 puis étape 304).

Dans le cas contraire, le rapport de courant (current_ratio) est comparé (étape 406) à un deuxième seuil (ici choisi égal à 1,1 bien que d'autres exemples soient possibles). Si le rapport calculé est supérieur au deuxième seuil, tout en étant inférieur au premier seuil, alors la ou les charges concernées sont interrompues après un premier délai de temporisation, par exemple égal à 20 secondes (étape 408 puis étape 304).

Dans le cas où aucune des deux conditions n'est remplie, alors à l'étape 410 le rapport de courant (noté « current ratio » sur la figure 4) est comparé à des seuils prédéfinis (ici égaux à 0,8 et 1,1 d'autres exemples étant néanmoins possibles). Si le rapport calculé est compris entre le premier seuil et le deuxième seuil alors la ou les charges concernées sont interrompues après un deuxième délai de temporisation, par exemple égal à 300 secondes (étape 412 puis étape 304).

Le procédé prend fin à l'étape 414.

En variante, les valeurs des seuils des rapports de courant (première et deuxième valeurs de seuil) pourraient prendre des valeurs différentes. Ces valeurs de seuil sont de préférence choisies en fonction des propriétés de l'élément de protection 11 de l'installation et du niveau de protection électrique souhaité, par exemple en fonction du calibre en courant maximal supporté par le répartiteur et/ou par les conducteurs électriques utilisés pour distribuer le courant entre les sources et les charges électriques. Il en va de même pour les valeurs de temporisation. Notamment, des première et deuxième valeurs de seuil peuvent être définies pour les différentes itérations du procédé (les première et deuxième finalités mentionnées ci-dessus).

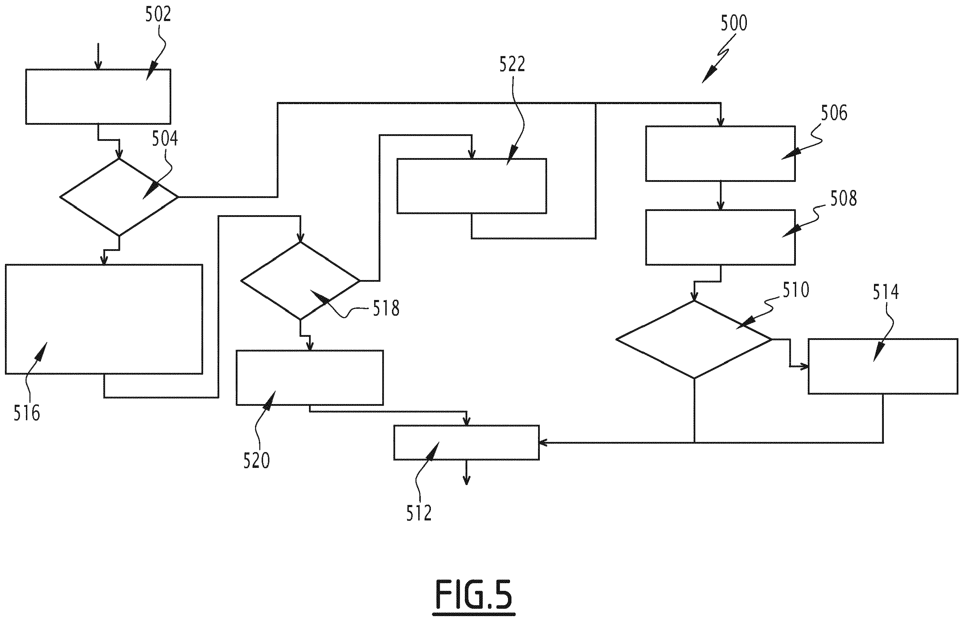

La figure 5 détaille un exemple de fonctionnement (procédé 500) de l'étape mise en oeuvre au bloc 304 susmentionné pour commander le délestage d'une ou de plusieurs charges électriques.

Dans cet exemple, le délestage agit en priorité sur certaines charges plutôt que d'autres (en particulier les charges facilement modulables ou déconnectables) en fonction de leur nature. Par exemple, on vise d'abord à déconnecter ou à limiter la charge du véhicule électrique, puis ensuite celle d'une charge telle que le chauffe-eau ou la climatisation. Le choix du chauffe-eau est ici justifié par le fait que l'arrêt provisoire du chauffe-eau ne dégradera pas le confort des utilisateurs puisqu'il existe une réserve d'eau chaude dans laquelle l'utilisateur peut puiser même lorsque les moyens de chauffage du chauffe-eau sont temporairement désactivés.

Le procédé débute à l'étape 502, une fois qu'un ordre de délestage a été émis et que, le cas échéant, la durée correspondant à la temporisation s'est écoulée.

A l'étape 504, le dispositif électronique de commande 100 vérifie si un véhicule électrique est connecté à la borne de chargement et vérifie si les batteries de ce véhicule ne sont pas pleines.

Si aucun véhicule n'est connecté ou si les batteries sont pleines, alors, dans une étape 506, le chauffe-eau est interrompu temporairement. Par exemple, le dispositif 100 commande la déconnexion de la charge électrique 80, ici au moyen du dispositif de commutation 120, puis déclenche un compteur de temps, pendant laquelle l'alimentation de la charge 80 restera interrompue.

Un nouveau rapport de courant est calculé lors de l'étape 508, puis une comparaison avec le seuil limite est réalisée lors d'une étape 510.

Par exemple, si le procédé complet est mis en oeuvre pour déterminer si le courant consommé est dans les limites des paramètres de l'abonnement souscrit auprès du gestionnaire du réseau 32, alors l'étape 510 peut comporter la comparaison du ratio avec une première valeur spécifiquement choisie en fonction du seuil défini dans le contrat.

Si la comparaison montre que le nouveau ratio est inférieur au seuil limite, alors le procédé 500 prend fin à l'étape 512. Un message peut être émis pour indiquer qu'un délestage est actif.

Dans le cas où la comparaison montre que le nouveau ratio est malgré tout supérieur au seuil limite, alors le dispositif électronique de commande 100 déconnecte une autre charge électrique.

Par exemple, lors d'une étape 514, on déconnecte la pompe à chaleur (ou climatiseur) (charge 82), ici au moyen du dispositif de commutation 124 et on impose une temporisation pendant laquelle cette charge ne sera pas réalimentée. Le procédé peut alors se terminer directement à l'étape 512.

Dans le cas où, à l'issue de l'étape 504, un véhicule a été identifié comme connecté à la borne de chargement et dont les batteries ne sont pas remplies, indiquant que le véhicule est potentiellement en cours de charge, alors, dans une étape 516, on calcule une nouvelle consigne de charge pour le véhicule électrique, par exemple pour réduire la puissance électrique consommée.

Lors d'une étape 518, le dispositif 100 vérifie si la consigne de charge de la station de charge est négative, indiquant que le courant à réduire est supérieur à la seule demande du véhicule électrique. Si tel est le cas, alors lors d'une étape 522 une nouvelle consigne de charge est choisie égale à zéro pour désactiver la borne de charge et le procédé passe à l'étape 506 précédemment décrite, pour déconnecter une autre charge.

Dans le cas où la consigne de charge de la station de charge est positive ou nulle, alors la nouvelle consigne de charge calculée est assignée à la borne de chargement qui sera transmise au véhicule électrique lors d'une étape 520. Le procédé prend ensuite fin à l'étape 512.

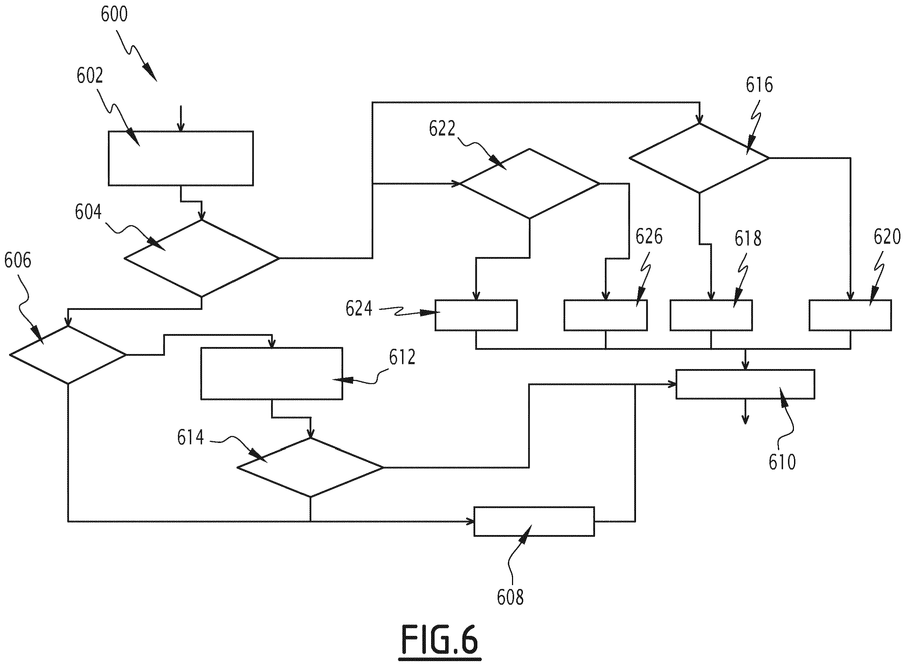

La figure 6 détaille un exemple (procédé 600) de fonctionnement de l'étape mise en oeuvre au bloc 306 susmentionné pour réactiver une ou plusieurs charges électriques une fois que le délestage doit prendre fin.

Le procédé débute à l'étape 602, une fois qu'un ordre de mettre fin au délestage a été émis.

A l'étape 604, le dispositif électronique de commande 100 vérifie si au moins l'un ou l'autre du chauffe-eau ou de la pompe à chaleur (ou climatiseur) est à l'arrêt, suite au délestage.

Si aucune de ces charges n'est identifiée comme étant arrêtée, alors, dans une étape 606, le dispositif 100 vérifie si un véhicule électrique est connecté à la borne de chargement et vérifie si les batteries de ce véhicule ne sont pas pleines.

Si aucun véhicule n'est connecté ou si les batteries sont pleines, alors, dans une étape 608, un message est envoyé (ou un registre est mis à jour) pour indiquer que le délestage est terminé. Le procédé prend ensuite fin lors d'une étape 610.

Dans le cas où, à l'issue de l'étape 606, un véhicule a été identifié comme connecté à la borne de chargement et dont les batteries ne sont pas remplies, indiquant que le véhicule est potentiellement en cours de charge, alors, dans une étape 612, le dispositif 100 calcule une nouvelle consigne de charge pour la borne de chargement, par exemple pour augmenter la puissance électrique consommée par le véhicule électrique.

Lors d'une étape 614, le dispositif 100 vérifie si la nouvelle consigne de charge calculée est supérieure à la consigne maximale. Si tel est le cas, alors le procédé passe à l'étape 608 et prend fin à l'étape 610.

Dans le cas où la nouvelle consigne de charge calculée est inférieure à la consigne maximale, alors on passe directement à l'étape 610.

De retour à l'étape 604, si le dispositif 100 identifie qu'au moins une des autres charges, telles que le chauffe-eau ou le climatiseur est déjà à l'arrêt, alors, une ou plusieurs vérifications sont mises en place.

Dans une étape 616, le dispositif 100 vérifie si la temporisation imposée à la pompe à chaleur (ou climatiseur) (charge 82) est arrivée à son terme. Si tel est le cas, alors, dans une étape 618, la charge 82 est reconnectée (par exemple en agissant sur le dispositif de commutation 124) pour réalimenter la pompe à chaleur (ou climatiseur). Dans le cas contraire, lors d'une étape 620, la charge 82 reste déconnectée. Le procédé prend fin à l'étape 610.

En parallèle, dans une étape 622, le dispositif 100 vérifie si la temporisation imposée au chauffe-eau (charge 80) est arrivée à son terme. Si tel est le cas, alors, dans une étape 624, la charge 80 est reconnectée (par exemple au moyen du dispositif de commutation 120) pour réalimenter le chauffe-eau. Dans le cas contraire, lors d'une étape 626, la charge 80 reste déconnectée. Le procédé prend fin à l'étape 610.

Là encore, en variante, les étapes pourraient être exécutées dans un ordre différent. Certaines étapes pourraient être omises. L'exemple décrit ne fait pas obstacle à ce que, dans d'autres modes de réalisation, d'autres étapes soient mises en oeuvre conjointement et/ou séquentiellement avec les étapes décrites.

Les modes de réalisation et les variantes envisagés ci-dessus peuvent être combinés entre eux pour donner naissance à de nouveaux modes de réalisation.

## Revendications

1. Système de distribution électrique (30) pour distribuer des courants électriques entre un réseau de distribution électrique et une installation domestique de distribution, dans lequel le système comporte :
▪ un répartiteur (36) agencé pour distribuer un courant électrique dans l'installation, le répartiteur étant configuré pour être connecté, côté amont, à un réseau de distribution électrique (32) et à au moins une source d'alimentation électrique secondaire (34, 50, 60), le répartiteur étant configuré pour être connecté, côté aval, à une pluralité des charges électriques (80, 82, 84, 86, 88),
▪ un dispositif électronique de commande (100) connecté à des dispositifs de mesure associés aux sources et aux charges , ces dispositifs de mesure permettant de déterminer le courant électrique circulant dans l'installation et notamment le courant électrique véhiculé dans le réseau de distribution électrique,
▪ le dispositif électronique de commande (100) étant configuré pour, en fonction du courant mesuré, gérer des paramètres d'alimentation d'au moins une partie des charges électriques afin de réduire le courant électrique consommé par ces charges électriques et/ou gérer des paramètres de fonctionnement d'au moins une partie des sources d'alimentation électrique secondaires pour réduire le courant électrique délivré par ces sources électriques,
le système de distribution électrique étant **caractérisé en ce que** le dispositif électronique de commande soit configuré afin de respecter ur premier seuil de courant imposé par un élément de protection (11) entre l'installation électrique et le réseau de distribution électrique et un deuxième seuil de courant correspondant à une limite en courant imposée par le répartiteur (36) afin d'éviter que le courant délivré par les sources électriques au travers du répartiteur (36) dépasse la limite en courant imposée par le répartiteur (36).

2. Système selon la revendication 1, dans lequel gérer des paramètres d'alimentation d'au moins une partie des charges électriques comporte des étapes consistant au moins à déconnecter ou reconnecter automatiquement ladite ou lesdites charges électriques (80, 82, 84, 86), ou moduler la consommation électrique de ladite ou desdites charges électriques.

3. Système selon l'une quelconque des revendications précédentes, dans lequel ladite pluralité de charges électriques (80, 82, 84, 86) comporte un ou plusieurs des éléments suivants : un véhicule électrique ou une station de charge d'un véhicule électrique, un chauffe-eau, une pompe à chaleur, ou climatiseur, ou une pompe.

4. Système selon l'une quelconque des revendications précédentes, dans lequel le système comporte un ou plusieurs dispositifs de commutation électrique (120, 124, 126) pour sélectivement déconnecter ou reconnecter une ou plusieurs desdites charges électriques, le ou les dispositifs de commutation étant pilotés par le dispositif électronique de commande.

5. Système selon l'une quelconque des revendications précédentes, dans lequel au moins une desdites charges électriques (86) comporte un dispositif de régulation intégré connecté au dispositif électronique de commande, le dispositif de régulation intégré étant configuré pour piloter la consommation électrique de ladite charge électrique en fonction d'informations envoyées par le dispositif électronique de commande.

6. Système selon la revendication précédente, dans lequel ladite charge électrique (86) est une station de charge pour un véhicule électrique.

7. Système selon l'une quelconque des revendications précédentes, dans lequel chacune desdites charges électriques (80, 82, 84, 86, 88) est raccordée au répartiteur par l'intermédiaire d'un conducteur électrique.

8. Système selon l'une quelconque des revendications précédentes, dans lequel au moins une source d'alimentation électrique secondaire comporte des générateurs photovoltaïques.

9. Système selon l'une quelconque des revendications précédentes, dans lequel le système comporte au moins un système de stockage d'électricité pouvant être source ou charge.

10. Système selon l'une quelconque des revendications précédentes, dans lequel une source d'alimentation électrique secondaire alternative (60) comporte un groupe électrogène.

11. Système selon l'une quelconque des revendications précédentes, dans lequel le répartiteur (36) comporte des conducteurs électriques en cuivre.

12. Système selon l'une quelconque des revendications précédentes, dans lequel l'élément de protection (11) comporte un appareil de protection électrique tel qu'un disjoncteur ou un fusible ou un compteur d'énergie à limitation de puissance.

13. Système selon l'une quelconque des revendications précédentes, dans lequel le répartiteur est également configuré pour être connecté, côté aval, à des charges électriques additionnelles (88), telles que des charges électriques domestiques, par exemple des éclairages.

14. Procédé de gestion d'un système de distribution électrique pour distribuer des courants électriques entre un réseau de distribution électrique et un tableau électrique dans une installation domestique, dans lequel le système comporte un répartiteur et un dispositif électronique de commande, le répartiteur étant agencé pour distribuer un courant électrique dans l'installation, le répartiteur étant configuré pour être connecté, côté amont, à un réseau de distribution électrique et à au moins une source d'alimentation électrique secondaire, le répartiteur étant configuré pour être connecté, côté aval, à une pluralité de charges électriques, dans lequel le dispositif électronique de commande est configuré pour :
déterminer, au moyen de dispositifs de mesure associés aux sources et aux charges, les courants électriques circulant dans l'installation, et notamment le courant électrique véhiculé dans le réseau de distribution électrique,
en fonction du courant mesuré, gérer des paramètres d'alimentation d'au moins une partie des charges électriques , afin de réduire le courant électrique consommé par ces charges électriques et/ou gérer des paramètres de fonctionnement d'au moins une partie des sources d'alimentation électrique secondaires pour réduire le courant électrique délivré par ces sources électriques,
le procédé de gestion étant **caractérisé en ce que** le dispositif électronique de commande soit configuré afin de respecter un premier seuil de courant imposé par ur élément de protection (11) entre l'installation électrique et le réseau de distribution électrique et un deuxième seuil de courant correspondant à une limite en courant imposée par le répartiteur (36) afin d'éviter que le courant délivré par les sources électriques au travers du répartiteur (36) dépasse la limite en courant imposée par le répartiteur (36).

## Patentansprüche

1. Elektrisches Verteilungssystem (30) zum Verteilen von elektrischen Strömen zwischen einem elektrischen Verteilungsnetz und einer Hausverteilungsanlage, wobei das elektrische Verteilungssystem Folgendes umfasst:
• einen Verteiler (36), der angeordnet ist, um elektrischen Strom in der Anlage verteilt, wobei der Verteiler konfiguriert ist, um stromaufwärts mit einem elektrischen Verteilungsnetz (32) und mit mindestens einer sekundären Stromversorgungsquelle (34, 50, 60) verbunden zu sein, wobei der Verteiler konfiguriert ist, um stromabwärts mit einer Vielzahl der elektrischen Lasten (80, 82, 84, 86, 88) verbunden zu sein,
• eine elektronische Steuervorrichtung (100), die mit Messvorrichtungen verbunden ist, die mit den Quellen und den Lasten assoziiert sind, wobei diese Messvorrichtungen es ermöglichen, den in der Anlage fließenden elektrischen Strom und insbesondere den im Stromverteilungsnetz transportierten elektrischen Strom zu bestimmen,
• wobei die elektronische Steuervorrichtung (100) konfiguriert ist, um abhängig von dem gemessenen Strom Parameter für die Stromversorgung mindestens eines Teils der elektrischen Lasten zu verwalten, um den von diesen elektrischen Lasten aufgenommenen elektrischen Strom zu reduzieren, und/oder Parameter für den Betrieb mindestens eines Teils der sekundären Stromquellen zu verwalten, um den von diesen Stromquellen bereitgestellten elektrischen Strom zu reduzieren,
wobei das Stromverteilungssystem **dadurch gekennzeichnet ist, dass** die elektronische Steuervorrichtung konfiguriert ist, um eine erste Stromschwelle, die von einem Schutzelement (11) zwischen der elektrischen Anlage und dem Stromverteilungsnetz auferlegt wird, und eine zweite Stromschwelle, die einer von dem Verteiler (36) auferlegten Stromgrenze entspricht, einzuhalten, um zu verhindern, dass der von den elektrischen Quellen durch den Verteiler (36) bereitgestellte Strom die von dem Verteiler (36) auferlegte Stromgrenze übersteigt.

2. System nach Anspruch 1, wobei ein Verwalten von Parametern für die Stromversorgung mindestens eines Teils der elektrischen Lasten Schritte umfasst, die mindestens darin bestehen, die elektrische Last oder die elektrischen Lasten (80, 82, 84, 86) automatisch zu trennen oder wieder zu verbinden oder den Stromverbrauch der elektrischen Last oder der elektrischen Lasten zu modulieren.

3. System nach einem der vorherigen Ansprüche, wobei die Vielzahl von elektrischen Lasten (80, 82, 84, 86) eine oder mehrere der folgenden Komponenten umfassen: ein Elektrofahrzeug oder eine Ladestation für ein Elektrofahrzeug, einen Warmwasserbereiter, eine Wärmepumpe oder Klimaanlage oder eine Pumpe.

4. System nach einem der vorherigen Ansprüche, wobei das System eine oder mehrere elektrische Schaltvorrichtungen (120, 124, 126) zum selektiven Trennen oder Wiederverbinden einer oder mehrerer der elektrischen Lasten umfasst, wobei die Schaltvorrichtung(en) von der elektronischen Steuervorrichtung gesteuert wird/werden.

5. System nach einem der vorherigen Ansprüche, wobei mindestens eine der elektrischen Lasten (86) eine integrierte Regelvorrichtung aufweist, die mit der elektronischen Steuervorrichtung verbunden ist, wobei die integrierte Regelvorrichtung konfiguriert ist, um die Stromaufnahme der elektrischen Last abhängig von Informationen zu steuern, die von der elektronischen Steuervorrichtung gesendet werden.

6. System nach dem vorherigen Anspruch, wobei die elektrische Last (86) eine Ladestation für ein Elektrofahrzeug ist.

7. System nach einem der vorherigen Ansprüche, wobei jede der elektrischen Lasten (80, 82, 84, 86, 88) über einen elektrischen Leiter mit dem Verteiler verbunden ist.

8. System nach einem der vorherigen Ansprüche, wobei mindestens eine sekundäre Stromversorgungsquelle photovoltaische Generatoren umfasst.

9. System nach einem der vorherigen Ansprüche, wobei das System mindestens ein Stromspeichersystem umfasst, das Quelle oder Last sein kann.

10. System nach einem der vorherigen Ansprüche, wobei eine alternative sekundäre Stromversorgungsquelle (60) ein Stromaggregat umfasst.

11. System nach einem der vorherigen Ansprüche, wobei der Verteiler (36) elektrische Leiter aus Kupfer umfasst.

12. System nach einem der vorherigen Ansprüche, wobei das Schutzelement (11) ein elektrisches Schutzgerät, wie beispielsweise einen Leistungsschalter oder eine Sicherung oder einen Energiezähler mit Leistungsbegrenzung umfasst.

13. System nach einem der vorherigen Ansprüche, wobei der Verteiler auch konfiguriert ist, um stromabwärts mit zusätzlichen elektrischen Lasten (88) verbunden zu sein, wie beispielsweise elektrischen Lasten im Haushalt, beispielsweise Beleuchtungen.

14. Verfahren zur Verwaltung eines Stromverteilungssystems zur Verteilung elektrischer Ströme zwischen einem Stromverteilungsnetz und einer Schalttafel in einer Hausanlage, wobei das System einen Verteiler und eine elektronische Steuervorrichtung umfasst, wobei der Verteiler angeordnet ist, um einen elektrischen Strom in der Installation zu verteilen, wobei der Verteiler konfiguriert ist, um stromaufwärts mit einem Stromverteilungsnetz und mindestens einer sekundären Stromversorgungsquelle verbunden zu sein, wobei der Verteiler konfiguriert ist, um stromabwärts mit einer Vielzahl von elektrischen Lasten verbunden zu sein, wobei die elektronische Steuervorrichtung zu Folgendem konfiguriert ist:
Bestimmen, mittels Messvorrichtungen, die mit den Quellen und Lasten verbunden sind, der elektrischen Ströme, die in der Anlage fließen, insbesondere den elektrischen Strom, der in dem Stromverteilungsnetz transportiert wird,
abhängig von dem gemessenen Strom, Verwalten der Parameter für die Stromversorgung mindestens eines Teils der elektrischen Lasten, um den von diesen elektrischen Lasten aufgenommenen elektrischen Strom zu reduzieren, und/oder Verwalten der Parameter für den Betrieb mindestens eines Teils der sekundären Stromquellen, um den von diesen Stromquellen bereitgestellten elektrischen Strom zu reduzieren,
wobei das Verwaltungsverfahren **dadurch gekennzeichnet ist, dass** die elektronische Steuervorrichtung konfiguriert ist, um eine erste Stromschwelle, die von einem Schutzelement (11) zwischen der elektrischen Anlage und dem Stromverteilungsnetz auferlegt wird, und eine zweite Stromschwelle, die einer von dem Verteiler (36) auferlegten Stromgrenze entspricht, einzuhalten, um zu verhindern, dass der von den elektrischen Quellen durch den Verteiler (36) bereitgestellte Strom die von dem Verteiler (36) auferlegte Stromgrenze übersteigt.

## Claims

1. An electricity distribution system (30) for distributing electric currents between an electrical distribution grid and a domestic distribution installation, wherein the system comprises:
• a distributor (36) arranged to distribute an electric current in the installation, the distributor being configured to have its upstream side connected to an electrical distribution grid (32) and to at least one secondary electrical power supply source (34, 50, 60), the distributor being configured to have its downstream side connected to a plurality of electrical loads (80, 82, 84, 86, 88),
• an electronic control device (100) connected to measuring devices associated with the sources and the loads, these measuring devices making it possible to determine the electric current flowing in the installation and in particular the electric current carried in the electrical distribution grid,
• the electronic control device (100) being configured, based on the measured current, to manage power supply parameters of at least some of the electrical loads to reduce the electric current consumed by these electrical loads and/or to manage operating parameters of at least some of the secondary electrical power supply sources in order to reduce the electric current delivered by these electrical sources,
the electricity distribution system being **characterized in that** the electronic control device is configured so as to comply with a first current threshold imposed by a protection element (11) between the electrical installation and the electrical distribution grid and/or a second current threshold corresponding to a current limit imposed by the distributor (36) so as to prevent the current delivered by the electrical sources through the distributor (36) from exceeding the current limit imposed by the distributor (36).

2. The system according to claim 1, wherein managing power supply parameters of at least some of the electrical loads comprises steps consisting in at least automatically disconnecting or reconnecting said electrical load(s) (80, 82, 84, 86), or modulating the electrical consumption by said electrical load(s).

3. The system according to any one of the preceding claims, wherein said plurality of electrical loads (80, 82, 84, 86) comprises one or more of the following elements: an electric vehicle or a charging station for an electric vehicle, a water heater, a heat pump, or air-conditioner, or a pump.

4. The system according to any one of the preceding claims, wherein the system comprises one or more electrical switching devices (120, 124, 126) for selectively disconnecting or reconnecting one or more of said electrical loads, the switching device(s) being controlled by the electronic control device.

5. The system according to any one of the preceding claims, wherein at least one of said electrical loads (86) comprises an integrated regulating device connected to the electronic control device, the integrated regulating device being configured to control the electrical consumption by said electrical load based on information sent by the electronic control device.

6. The system according to the preceding claim, wherein said electrical load (86) is a charging station for an electric vehicle.

7. The system according to any one of the preceding claims, wherein each of said electrical loads (80, 82, 84, 86, 88) is connected to the distributor by way of an electrical conductor.

8. The system according to any one of the preceding claims, wherein at least one secondary electrical power supply source comprises photovoltaic generators.

9. The system according to any one of the preceding claims, wherein the system comprises at least one electricity storage system that may be a source or a load.

10. The system according to any one of the preceding claims, wherein an alternative secondary electrical power supply source (60) comprises a generator set.

11. The system according to any one of the preceding claims, wherein the distributor (36) comprises copper electrical conductors.

12. The system according to any one of the preceding claims, wherein the protection element (11) comprises an electrical protection apparatus such as a circuit breaker or a fuse or a power-limited energy meter.

13. The system according to any one of the preceding claims, wherein the distributor is also configured to have its downstream side connected to additional electrical loads (88), such as domestic electrical loads, for example lighting.

14. A method for managing an electricity distribution system for distributing electric currents between an electrical distribution grid and an electrical switchboard in a domestic installation, wherein the system comprises a distributor and an electronic control device, the distributor being arranged to distribute an electric current in the installation, the distributor being configured to have its upstream side connected to an electrical distribution grid and to at least one secondary electrical power supply source, the distributor being configured to have its downstream side connected to a plurality of electrical loads, wherein the electronic control device is configured to:
determine, by means of measuring devices associated with the sources and with the loads, the electric currents flowing in the installation, and in particular the electric current carried in the electrical distribution grid,
based on the measured current, manage power supply parameters of at least some of the electrical loads to reduce the electric current consumed by these electrical loads and/or to manage operating parameters of at least some of the secondary electrical power supply sources in order to reduce the electric current delivered by these electrical sources,
the management method being **characterized in that** the electronic control device is configured so as to comply with a first current threshold imposed by a protection element (11) between the electrical installation and the electrical distribution grid and a second current threshold corresponding to a current limit imposed by the distributor (36) so as to prevent the current delivered by the electrical sources through the distributor (36) from exceeding the current limit imposed by the distributor (36).
